# FASCICULE DE BREVET EUROPEEN

(11) **EP 2 734 897 B1**
(45) Date de publication et mention de la délivrance du brevet: **12.06.2024**
(21) Numéro de dépôt: 12737539.2
(22) Date de dépôt: 17.07.2012
(51) Int. Cl.: G04B 1/14, G04B 15/14, G04B 31/004, G04B 13/02, B81C 99/00

(54) **ENSEMBLE FONCTIONNEL DE MICROMECANIQUE**
MIKROMECHANISCHE FUNKTIONSANORDNUNG
FUNCTIONAL MICROMECHANICAL ASSEMBLY

(30) Priorité: 21.07.2011 EP 11005979; 14.10.2011 EP 11185240
(43) Date de publication de la demande: 28.05.2014
(73) Titulaire: The Swatch Group Research and Development Ltd., 2074 Marin (CH)
(72) Inventeur: RICHARD, David, 1400 Yverdon-les-Bains (CH); BOURBAN, Stewes, 1589 Chabrey (CH)
(74) Mandataire: ICB SA
(86) Numéro de dépôt international: PCT/EP2012/064017
(87) Numéro de publication internationale: WO 2013/011032

(56) Documents cités:
- EP-A1- 1 649 955
- EP-A1- 2 107 434
- EP-A1- 2 236 455
- WO-A1-2009/115519
- WO-A2-2004/029733
- US-H- H1 792
- SCHADE A ET AL: "Tribological behaviour of <100> and <111> fibre textured CVD diamond films under dry planar sliding contact", DIAMOND AND RELATED MATERIALS, ELSEVIER SCIENCE PUBLISHERS, AMSTERDAM, NL, vol. 15, no. 10, 1 octobre 2006 (2006-10-01), pages 1682-1688, XP028000726, ISSN: 0925-9635, DOI: 10.1016/J.DIAMOND.2006.02.008 [extrait le 2006-10-01]
- CAPPELLI ET AL: "Diamond nucleation and growth on different cutting tool materials: influence of substrate pre-treatments", DIAMOND AND RELATED MATERIALS, ELSEVIER SCIENCE PUBLISHERS, AMSTERDAM, NL, vol. 5, no. 3-5, 1 avril 1996 (1996-04-01) , pages 292-298, XP005309764, ISSN: 0925-9635, DOI: 10.1016/0925-9635(95)00426-2

## Description

### DOMAINE TECHNIQUE DE L'INVENTION

La présente invention concerne un ensemble fonctionnel de micromécanique horlogère comprenant une première pièce comprenant une première couche définissant une première surface de contact destinée à venir en contact de frottement avec une deuxième surface de contact définie par une deuxième couche ladite deuxième couche appartenant, soit à ladite première pièce, soit à au moins une deuxième pièce de micromécanique constituant avec ladite première pièce ledit ensemble. Elle concerne plus particulièrement un couple de pièces micromécaniques horlogères coopérant mécaniquement l'une avec l'autre telles qu'une roue d'échappement et des palettes d'ancre.

### ETAT DE LA TECHNIQUE ANTERIEURE

Les récentes constructions de mouvements horlogers mécaniques avec un échappement silicium revêtu de diamant (palettes et roue d'échappement), et sans lubrification liquide volontaire du contact palette/roue d'échappement ne fonctionnent pas de manière satisfaisante. En effet le pouvoir réglant d'un tel échappement non lubrifié est inférieur à ceux des dispositifs d'échappement comprenant une lubrification conventionnelle. La demanderesse a constaté dans certains cas que l'échappement non lubrifié cessait de fonctionner après quelques heures suite à une dégradation irréversible des performances tribologiques des revêtements de l'échappement.

La seule approche d'échappement revêtu de diamant non lubrifiée qui semble efficace consiste à polir préalablement les surfaces de frottement en diamant avant leur montage dans le mouvement horloger.

Cela est toutefois laborieux et incompatible avec les exigences d'une fabrication industrielle avec un prix de revient acceptable.

Dans les applications micromécaniques, la plupart des couches diamant utilisées sont de nature nanocristalline (taille de grains <50nm, Ra<50nm) car intuitivement, l'homme du métier croit que plus les surfaces sont lisses, mieux elles frottent les unes sur les autres.

Les documents EP2107434A1, EP2236455A1, WO2009/115519A1 et WO2004/029733A2 décrivent des ensembles de micromécanique horlogère comportant chacun deux pièces recouvertes en diamant et frottant l'une avec l'autre.

La publication de Schade et al, intitulée "Tribological behaviour of {100} and {111} fibre textured CVD diamond films under dry planar sliding contact", publié chez Elsevier, Diamond and related materials, vol. 15, no. 10, 1 octobre 2006, pages 1682-1688, présente une étude des frottements de deux pièces de micromécanique, la première étant recouverte par une couche en diamant avec plans cristallins apparentant à la famille {100} et la seconde étant recouverte par une couche en diamant avec plans cristallins apparentant à la famille {111}.

Le but principal de la présente invention est de fournir une solution tribologique permettant de faire frotter des composants micromécaniques sans lubrification de manière fiable et durable notamment dans des applications horlogères et qui pallie au moins les inconvénients de l'art antérieur mentionnés plus haut.

L'invention a également pour objet de fournir un ensemble fonctionnel de micromécanique, en particulier horloger, comportant des éléments mobiles avec des caractéristiques tribologiques améliorées qui ne nécessitent pas d'étapes de post traitement tel qu'un polissage.

### EXPOSE DE L'INVENTION

A cet effet l'invention concerne un ensemble fonctionnel de micromécanique horlogère tel que défini dans la revendication indépendante 1 annexée. Des modes de réalisation préférés sont définis dans les revendications dépendantes.

Grâce à un tel agencement, il est possible de faire fonctionner un couple de pièces micromécaniques, comme par exemple le couple palettes d'ancre/roue d'échappement d'un mouvement horloger sans lubrification. La demanderesse a constaté que les performances tribologiques d'un tel ensemble fonctionnel dans cette application sont aussi bonnes voire meilleures que celles des échappements de l'état de l'art avec lubrification liquide.

Les première et deuxième couches de la ou desdites pièces micromécaniques agencées selon une telle configuration présentent une plus grande résistance à l'usure. Par ailleurs, les pertes énergétiques dues aux frottements entre deux surfaces de contact des couches sont fortement réduites de sorte que l'ensemble fonctionnel de micromécanique présente ainsi de meilleures caractéristiques tribologiques par rapport à des couples de surfaces de frottement antagonistes de même structure. Le phénomène résultant de la mise en frottement de surfaces de structure identique, couramment désigné par le terme anglais « interlocking », est supprimé par l'agencement de la présente invention. Selon l'invention, au moins ladite première couche présente au moins au niveau de sa surface de contact une structure microcristalline, et de préférence lesdites première et deuxième couches présentent au moins au niveau de leur surface de contact chacune une structure microcristalline. Typiquement, la taille des grains desdites première et/ou deuxième couches au moins au niveau de leur surface de contact respective est supérieure à 200nm et inférieure à 10 micromètres.

Selon l'invention, les plans cristallins desdites première et/ou deuxième couches présentent au moins au niveau de leur surface de contact respective chacune des orientations différentes selon des directions prédéterminées, faisant intervenir la direction [100] de la famille des directions <100> ou la direction [111] de la famille des directions <111>.

De préférence, on associera un des plans cristallins de la famille des plans cristallins {100} de ladite première couche au moins au niveau de la première surface de contact et un des plans cristallins de la famille des plans cristallins {111} de ladite deuxième couche au moins au niveau de la deuxième surface de contact.

Selon l'invention revendiquée, l'angle moyen défini par les normales aux plans cristallins (100) de la famille {100} et (111) de la famille {111} des couches au moins au niveau de leur surface de contact respective est compris entre 10° et 70°, de préférence entre 40° et 50°, et plus préférentiellement de 45°.

Selon un mode de réalisation avantageux la première pièce est réalisée en diamant massif mono ou polycristallin.

Selon une variante de réalisation de l'invention, ladite première et/ou deuxième couche de frottement définissant ladite première surface de contact et/ou ladite deuxième surface de contact recouvre un premier et/ou un deuxième substrat pour former ladite première et/ou ladite deuxième pièce. Typiquement le premier et/ou le deuxième substrat peut être en silicium ou en acier ou en céramique, avec ou sans couche intermédiaire de type chrome, titane, nickel, etc.. Dans le cas d'un substrat en silicium, ce dernier peut être nitruré, carburé, oxydé ou brut.

Selon une autre variante, la première et/ou la deuxième pièce sont réalisées en diamant massif mono ou polycristallin définissant ainsi directement les première et/ou deuxième surfaces de contact. Que ladite première et/ou ladite deuxième couche soient déposées sur un substrat ou massive, l'épaisseur de ces couches est au moins supérieure à 150nm. Pour des pièces massives, l'épaisseur de la première couche peut atteindre jusqu'à 1mm. Pour des pièces avec substrat, la première et/ou deuxième couche déposée peut atteindre jusqu'à 50 micromètres d'épaisseur.

L'ensemble fonctionnel de micromécanique de la présente invention trouve des applications avantageuses dans le domaine de l'horlogerie. En particulier, la première pièce peut être une palette et la deuxième pièce une roue d'échappement ou inversement. Dans une autre application horlogère, la première pièce peut être un axe d'un mobile et la deuxième pièce un palier ou inversement. Selon une autre application de ce domaine, les première et deuxième pièces peuvent être des dentures de roues d'engrenage. Dans un tel couple d'éléments, les surfaces de contact des pièces en contact de frottement ne subissent pas de dégradation irréversible de leurs performances tribologiques et présentent une bonne stabilité. Il est possible de prévoir un fonctionnement d'un système mobile horloger, tel qu'un échappement à ancre suisse sans lubrification du contact palette/roue d'échappement, avec des performances au moins équivalentes aux références standard. Les couches de frottement (massive ou sur substrat) de la présente invention, notamment de diamant, sont immédiatement performantes, sans avoir à modifier par post-traitement la nature des surfaces de frottement (par exemple par polissage, terminaison de surface, etc.). Dans une application horlogère n'impliquant qu'une seule pièce selon l'invention, celle-ci peut être un ressort de barillet formée d'une lame, une face avant de ladite lame formant ladite première surface de contact, et la face arrière de ladite lame formant ladite deuxième surface de contact. Il va de soi que dans des applications particulières l'ensemble fonctionnel de micromécanique de l'invention, une pièce peut venir en contact de frottement avec deux ou plusieurs autres pièces. Dans ce cas, les surfaces de frottement des pièces venant en contact l'une avec l'autre présenteront des orientations des plans cristallins, différentes l'une de l'autre conformément à l'invention.

Les couches de la présente invention sont avantageusement formées par la technologie CVD à filament chaud ou par la technologie micro-onde. Le diamant peut aussi être massif, issu ou non d'une croissance. Les orientations souhaitées des plans cristallins (par exemple (100) et (111)) sont obtenues en faisant notamment varier les proportions de gaz réactifs dans l'enceinte de dépôt ainsi que les paramètres de pressions et températures comme cela est par exemple décrit dans la publication de Y. Avigal et al intitulée « [100]- Textured diamond films for tribological applications » publiée chez Elsevier dans la revue Diamond and Related Materials, vol. 6 1997, pages 381- 385 notamment § 3.1, dans la publication de Qijin Chen et al intitulée « Oriented and textured growth of (111) diamond on silicon using hot filament chemical vapor déposition » publiée chez Elsevier dans la revue Thin Solid Films vol. 274 1996 pages 160 - 164 et dans la publicaton de M. Grujjicic and S.G. Lai publiée dans le Journal of Materials Synthesis and Processing, Vol. No 2 , 200 pages 73 - 85.

### DESCRIPTION DES FIGURES

D'autres caractéristiques et avantages de l'ensemble fonctionnel de micromécanique selon l'invention ressortiront également de la description détaillée suivante de modes de réalisation de cet ensemble, cette description étant effectuée à l'aide des dessins annexés, donnés à titre d'exemples nullement limitatifs et dans lesquels :
- la figure 1 est une représentation schématique en vue agrandie d'un exemple de deux surfaces de contact de deux pièces micromécaniques formant un ensemble fonctionnel de micromécanique et présentant respectivement des orientations de plans cristallins (111) et (100) selon l'invention;
- la figure 2 est une représentation schématique en vue agrandie de la surface de contact d'une des pièces micromécaniques de la figure 1 qui présente une orientation selon la direction [100] et illustrant l'angle de tilt de chacun des plans cristallins (100) ;
- la figure 3 est une vue partielle de coté d'une palette présentant un plan de repos A et un plan d'impulsion B coopérant avec les plans de repos C et d'impulsion D d'une roue d'échappement, les plans A et B définissant la première surface de contact et les plans C et D définissant la deuxième surface de contact selon l'invention ; et
- la figure 4 est une vue de dessus d'une lame de ressort de barillet présentant une face avant et une face arrière définissant respectivement les première et deuxième surfaces de contact selon l'invention ;

### DESCRIPTION DETAILLEE DE L'INVENTION

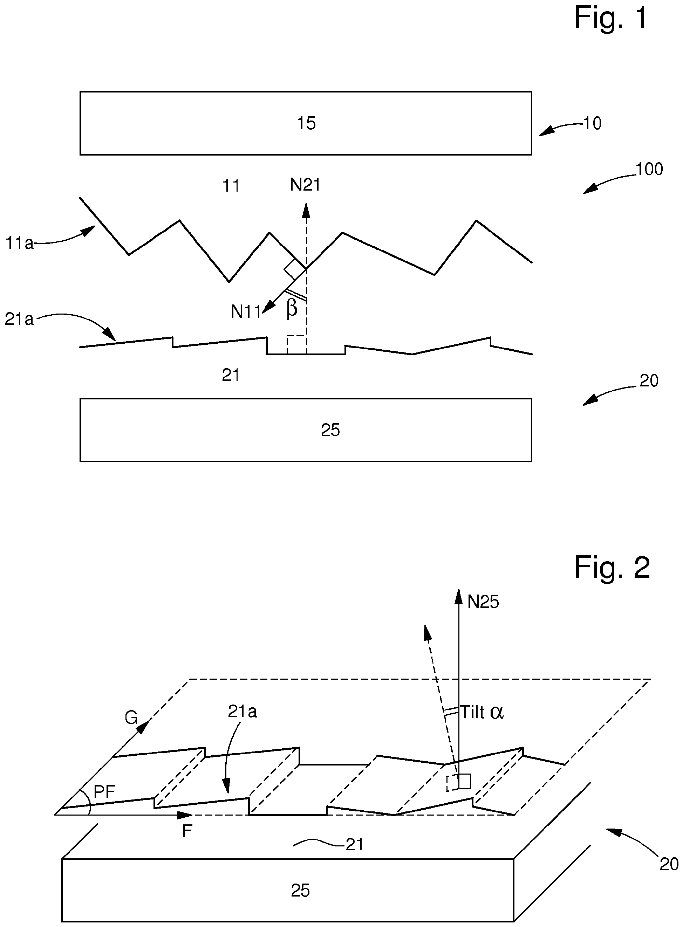

La figure 1 illustre un exemple de mode de réalisation d'un couple de pièces micromécaniques 10 et 20 selon l'invention. La première pièce 10 comporte un substrat 15 sur lequel est déposée une couche de diamant 11 présentant une surface de contact 11a destinée à venir en contact de frottement avec une deuxième surface de contact 21a définie par une deuxième couche 21. La couche 11 présente au niveau de la surface de contact 11a des plans cristallins orientés selon une direction prédéterminée à savoir la direction [111]. Au moins au niveau de la surface de contact 11a, la couche 11 est microcristalline, avec des tailles de grains supérieures à 200nm et une rugosité Rms supérieure à 80nm.

La pièce micromécanique 20 comporte un substrat 25 sur lequel est déposée la couche de diamant 21 présentant une surface de contact 21a en opposition à la surface 11a de la pièce micromécanique10. Les couches 11 et 21 forment ainsi des couches frottement.

Au moins au niveau de la surface de contact 21a la couche 21 présente ses plans cristallins orientés selon une direction prédéterminée à savoir la direction [100]. En pratique ces plans cristallins sont sensiblement inclinés par rapport à la direction de frottement F en raison de défauts de croissance inéluctables propres au procédé conventionnel d'obtention de la couche 21. Au moins au niveau de la surface de contact 21a, la couche 21 est microcristalline, et présente des tailles de grains supérieures à 200nm.

Au moins au niveau des surfaces de contact 11a et 21a destinées à venir en contact de frottement l'une avec l'autre les couches 11 et 21 présentent donc des orientations de plans cristallins différentes et dans cet exemple, ces deux orientations sont selon les directions [100] et [111]. En se référant à la figure 1 on voit qu'il est aussi possible de définir la différence d'orientation des plans cristallins des surfaces 11a et 21a par l'angle β qui est l'angle moyen formé par les normales N11 et N21 aux plans cristallins des surfaces de contact 11a et 21a β est compris entre 10° et 70°, de préférence entre 40° et 50° et plus préférentiellement égale à 45°. L'angle β_{moy} correspond à la moyenne des différences angulaires d'orientations cristallines β des deux surfaces de contact 11a et 21a. Cet angle est facilement calculable par l'homme du métier du diamant car il s'agit là d'un critère important dans la maîtrise du procédé de dépôt de diamant.

La figure 2 montre à nouveau la pièce micromécanique 20, considérée isolément, de façon à pouvoir illustrer l'angle de « tilt » α. Cet angle est mesuré entre la normale locale à la surface 21a d'une part et d'autre part à la normale NF au plan théorique de frottement PF (en pointillé sur la figure) qui est défini par la direction de frottement F et une droite G appartenant à la surface théorique définissant la surface 21a.

L'angle α est calculé par rapport au plan théorique de frottement PF. Il représente la moyenne des angles αᵢ entre la normale N25 et la normale aux plans (100) N21 à la figure 2. L'angle α_{moy} est de préférence inférieur à 30°, et plus préférentiellement inférieur à 10°.

Typiquement les couches 11 et 21 présentent une épaisseur d'au moins 150nm et de préférence d'environ 2,5 micromètres afin d'obtenir des orientations de plans cristallins homogènes.

Plus généralement les couches 11 et 21 définissant les surfaces 11a et 21a comportent chacune du carbone à hauteur d'au moins 50% d'atomes de carbone. Par exemple, ces couches peuvent être formées de diamant, de DLC (Diamond Like Carbon) de graphite ou d'une combinaison de ces matériaux

Selon une variante de réalisation non représentée les surfaces 11a et/ou 21a sont recouvertes au moins partiellement d'une couche de couverture d'un autre matériau que celui constituant les couches 11 et/ou 21. Ces couches de couverture pourront par exemple être formées d'un film d'or, de nickel ou de titane. Ces couches de couverture ne devront de préférence pas présenter une épaisseur supérieure à 100nm. Dans ce cas, la texture superficielle des première et deuxième surfaces de contact présente avantageusement les orientations des plans cristallins en surface, différentes l'une de l'autre conforme à l'invention.

Les couches 11 et 21 des pièces micromécaniques 10 et 20 sont déposables sur des substrats réalisés en tous types de matériaux adaptés au dépôt de couche de diamant, de DLC (Diamond Like Carbon), ou de graphite. Par exemple les substrats 15 et 25 pourront être choisis parmi l'ensemble de matériaux comprenant les céramiques, le silicium, le silicium désoxydé, le silicium oxydé, le silicium nitruré, le silicium carburé et les aciers.

La réalisation des surfaces de contact 11a et 21a de l'invention peut être également envisagée sans utiliser de substrat pour l'une et/ou l'autre des pièces micromécaniques. En effet les surfaces 11a et/ou 21a peuvent selon une variante de l'invention être issues de diamant massif monocristallin ou polycristallin.

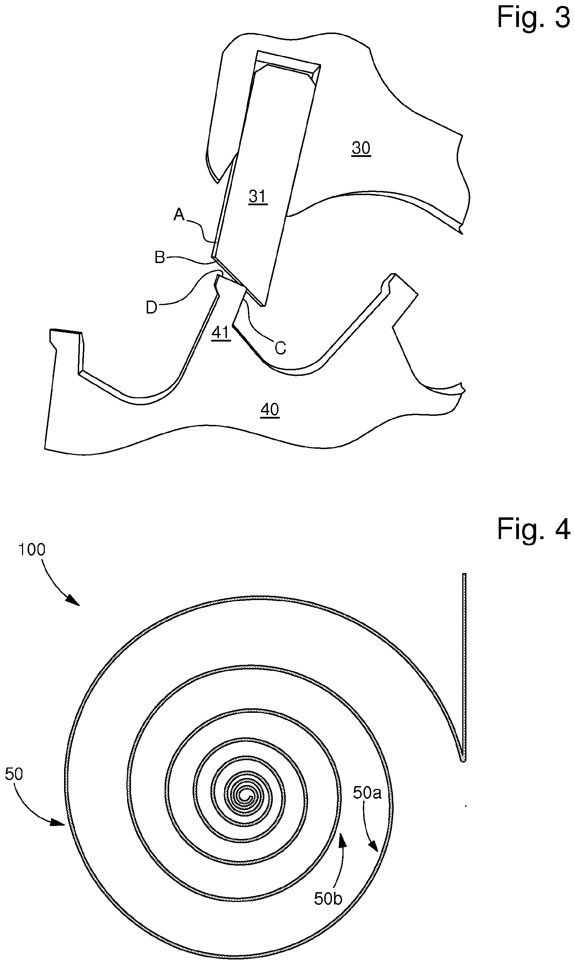

La figure 3 montre un exemple d'application de l'invention à la réalisation d'un échappement horloger dans lequel une ancre 30 comprend une palette 31 qui coopère avec une dent 41 d'une roue d'échappement 40. La palette 31 présente un plan de repos A et un plan d'impulsion B qui coopèrent avec les plans de repos C et d'impulsion D de la dent 41. Les plans de repos A et d'impulsion B présentent par exemple une surface de contact conforme à la surface 11a et les plans C et D présentent alors une surface de contact conforme à la surface 21a respectivement décrites en liaison avec les figures 1 et 2. Ces plans A, B, C, D correspondent à des zones fortement sollicitées et sujettes à des niveaux élevés de frottement et/ou contact. Selon une variante, l'ancre 30 peut venir de matière avec la palette 31.

A la figure 4, on voit une autre application horlogère de l'invention dans laquelle une lame 50 de ressort de barillet présente une face avant 50a et une face arrière 50b qui sont respectivement conformes aux surfaces de contact 11a et 21a décrites en liaison avec les figures 1 et 2.

Néanmoins, il est évident pour un homme du métier que l'invention peut être étendue à d'autres modes de réalisation non représentés dans lesquels par exemple, les pièces micromécaniques 10 et 11 sont constituées d'un axe de mobile tel qu'un pivot et d'un palier telle qu'une pierre ou d'un couple de dentures de roues d'engrenage, ou tout autre couple d'éléments fortement sujets à d'intenses sollicitations mécaniques de nature tribologique ou pas.

## Revendications

1. Ensemble fonctionnel (100) de micromécanique horlogère comprenant au moins une première pièce (10) munie au moins d'une première face, ladite au moins première face étant recouverte d'une première couche (11) définissant une première surface de contact (11a) destinée à venir en contact de frottement avec une deuxième surface de contact (21a) définie par une deuxième couche (21) recouvrant au moins une deuxième face , soit de ladite première pièce (10) soit d'au moins une deuxième pièce de micromécanique horlogère (20) constituant avec ladite première pièce (10) ledit ensemble (100), les première et deuxième couches (11, 21) comportant chacune du carbone à hauteur d'au moins 50% d'atomes de carbone, **caractérisé en ce que** la première surface de contact présente une première orientation déterminée de plans cristallins, **en ce que** la deuxième surface de contact présente une deuxième orientation déterminée de plans cristallins, **en ce que** les première et deuxième orientations déterminées sont différentes l'une de l'autre et **en ce que** les plans cristallins de ladite première couche au moins au niveau de la première surface de contact appartiennent à la famille de plans {111}, **en ce que** la direction des plans cristallins de ladite première couche appartenant à la famille de plans {111} est inclinée d'un angle moyen compris entre 10° et 70°, de préférence entre 40° et 50°, et plus préférentiellement de 45° par rapport à la normale à ladite première face, **en ce que** les plans cristallins de ladite deuxième couche au moins au niveau de la deuxième surface de contact appartiennent à la famille de plans {100} et **en ce que** la direction des plans cristallins de ladite deuxième couche appartenant à la famille de plans {100} est orientée de façon perpendiculaire à ladite deuxième face.

2. Ensemble fonctionnel de micromécanique horlogère selon la revendication 1, **caractérisé en ce qu'**au moins ladite première couche (11) présente une structure microcristalline au moins au niveau de la première surface de contact.

3. Ensemble fonctionnel de micromécanique horlogère selon la revendication 2, **caractérisé en ce que** lesdites première et deuxième couches (11, 21) présentent chacune une structure microcristalline au moins au niveau de leur surface de contact respective.

4. Ensemble fonctionnel de micromécanique horlogère selon l'une quelconque des revendications précédentes, **caractérisé en ce qu'**au moins l'une des première ou deuxième couches est recouverte au moins partiellement d'une couche de couverture d'un autre matériau.

5. Ensemble fonctionnel de micromécanique horlogère selon la revendication 4, **caractérisé en ce que** la couche de couverture est d'épaisseur inférieure à 100 nm.

6. Ensemble fonctionnel de micromécanique horlogère selon l'une quelconque des revendications précédentes, **caractérisé en ce que** ladite deuxième couche appartient à ladite deuxième pièce (20) et **en ce que** la première et/ou la deuxième pièce sont réalisées en diamant massif mono ou polycristallin.

7. Ensemble fonctionnel de micromécanique horlogère selon l'une quelconque des revendications précédentes, **caractérisé en ce que** la rugosité moyenne (Rₘₛ) d'une des première ou deuxième surfaces de contact est supérieure à 80 nm.

8. Ensemble fonctionnel de micromécanique horlogère selon l'une quelconque des revendications 1 à 7 lorsqu'elle ne dépend pas de la 9, **caractérisé en ce que** ladite première et/ou deuxième couche définissant ladite première surface de contact et/ou ladite deuxième surface de contact recouvre un premier substrat pour former ladite première pièce

9. Ensemble fonctionnel de micromécanique horlogère selon l'une quelconque des revendications 1 à 7 lorsqu'elle ne dépend pas de la 5, **caractérisé en ce que** ladite deuxième couche appartient à ladite deuxième pièce (20) et **en ce que** ladite première et/ou deuxième couche définissant ladite première surface de contact et/ou ladite deuxième surface de contact recouvre un premier substrat et/ou un deuxième substrat pour former ladite première et/ou ladite deuxième pièce.

10. Ensemble fonctionnel de micromécanique horlogère selon la revendication 7 ou 9, **caractérisé en ce que** le premier et/ou le deuxième substrat est constitué de silicium ou d'acier ou de céramique.

11. Ensemble fonctionnel de micromécanique horlogère selon l'une des revendications 7 à 10, **caractérisé en ce que** ladite première et/ou deuxième couche de frottement présentent une épaisseur d'au moins 150nm.

12. Ensemble fonctionnel de micromécanique horlogère selon l'une quelconque des revendications 1 à 11, **caractérisé en ce que** ladite deuxième couche appartient à ladite deuxième pièce (20) et **en ce que** la première pièce est une palette (30) et **en ce que** la deuxième pièce est une roue d'échappement (40) ou inversement.

13. Ensemble fonctionnel de micromécanique horlogère selon l'une quelconque des revendications 1 à 11, **caractérisé en ce que** ladite deuxième couche appartient à ladite deuxième pièce (20) et **en ce que** la première pièce est un axe d'un mobile et **en ce que** la deuxième pièce est un palier ou inversement.

14. Ensemble fonctionnel de micromécanique horlogère selon l'une quelconque des revendications 1 à 10 **caractérisé en ce que** ladite deuxième couche appartient à ladite deuxième pièce (20) et **en ce que** lesdites première et deuxième pièces sont des dentures de roues d'engrenage.

15. Ensemble fonctionnel de micromécanique horlogère selon l'une quelconque des revendications 1 à 10, **caractérisé en ce que** ladite deuxième couche appartient à ladite première pièce (10) et **en ce que** la première pièce est un ressort de barillet formé d'une lame et **en ce qu'**une face avant de ladite lame forme ladite première surface de contact et **en ce que** la face arrière de ladite lame forme ladite deuxième surface de contact.

## Patentansprüche

1. Funktionelle Einheit (100) der Uhrenmikromechanik mit mindestens einem ersten Teil (10), das mit mindestens einer ersten Seite versehen ist, wobei die mindestens eine erste Seite mit einer ersten Schicht (11) bedeckt ist, die eine erste Kontaktfläche (11a) definiert, die dazu bestimmt ist, in Reibungskontakt mit einer zweiten Kontaktfläche (21a) zu kommen, die durch eine zweite Schicht (21) definiert ist, die mindestens eine zweite Seite bedeckt, entweder des ersten Teils (10) oder mindestens eines zweiten Teils (20) der Uhrenmikromechanik, das mit dem ersten Teil (10) die Einheit (100) bildet, wobei die erste und die zweite Schicht (11, 21) jeweils Kohlenstoff in Höhe von mindestens 50 % der Kohlenstoffatome enthalten, **dadurch gekennzeichnet, dass** die erste Kontaktfläche eine erste bestimmte Ausrichtung der Kristallebenen aufweist, dass die zweite Kontaktfläche eine zweite bestimmte Ausrichtung der Kristallebenen aufweist, dass die erste und die zweite bestimmte Orientierung voneinander verschieden sind und dass die Kristallebenen der ersten Schicht zumindest an der ersten Kontaktfläche zur Familie der {111}-Ebenen gehören, dass die Richtung der Kristallebenen der ersten Schicht, die zur Familie der {111}-Ebenen gehören, um einen mittleren Winkel zwischen 10° und 70° geneigt ist, vorzugsweise zwischen 40° und 50° und besonders bevorzugt um 45° zur Normalen der ersten Seite, dass die Kristallebenen der zweiten Schicht zumindest an der zweiten Kontaktfläche zur Familie der {100}-Ebenen gehören und dass die Richtung der Kristallebenen der zweiten Schicht, die zur Familie der {100}-Ebenen gehören, senkrecht zur zweiten Seite orientiert ist.

2. Funktionelle Einheit der Uhrenmikromechanik nach Anspruch 1, **dadurch gekennzeichnet, dass** mindestens die erste Schicht (11) zumindest an der ersten Kontaktfläche eine mikrokristalline Struktur aufweist.

3. Funktionelle Einheit der Uhrenmikromechanik nach Anspruch 2, **dadurch gekennzeichnet, dass** die erste und die zweite Schicht (11, 21) jeweils eine mikrokristalline Struktur zumindest an ihrer jeweiligen Kontaktfläche aufweisen.

4. Funktionelle Einheit der Uhrenmikromechanik nach einem der vorhergehenden Ansprüche, **dadurch gekennzeichnet, dass** mindestens eine der ersten oder zweiten Schichten zumindest teilweise mit einer Deckschicht aus einem anderen Material bedeckt ist.

5. Funktionelle Einheit der Uhrenmikromechanik nach Anspruch 4, **dadurch gekennzeichnet, dass** die Deckschicht eine Dicke von weniger als 100 nm aufweist.

6. Funktionelle Einheit der Uhrenmikromechanik nach einem der vorhergehenden Ansprüche, **dadurch gekennzeichnet, dass** die zweite Schicht zu dem zweiten Teil (20) gehört und dass das erste und/oder das zweite Teil aus massivem mono- oder polykristallinem Diamant hergestellt sind.

7. Funktionelle Einheit der Uhrenmikromechanik nach einem der vorhergehenden Ansprüche, **dadurch gekennzeichnet, dass** die durchschnittliche Rauheit (Rₘₛ) einer der ersten oder zweiten Kontaktflächen größer als 80 nm ist.

8. Funktionelle Einheit der Uhrenmikromechanik nach einem der Ansprüche 1 bis 7, wenn sie nicht von 9 abhängt, **dadurch gekennzeichnet, dass** die erste und/oder zweite Schicht, die die erste Kontaktfläche und/oder die zweite Kontaktfläche definiert, ein erstes Substrat bedeckt, um das erste Teil zu bilden

9. Funktionelle Einheit der Uhrenmikromechanik nach einem der Ansprüche 1 bis 7, wenn sie nicht von 5 abhängt, **dadurch gekennzeichnet, dass** die zweite Schicht zu dem zweiten Teil (20) gehört und dass die erste und/oder zweite Schicht, die die erste Kontaktfläche und/oder die zweite Kontaktfläche definiert, ein erstes Substrat und/oder ein zweites Substrat bedeckt, um das erste und/oder das zweite Teil zu bilden.

10. Funktionelle Einheit der Uhrenmikromechanik nach Anspruch 7 oder 9, **dadurch gekennzeichnet, dass** das erste und/oder das zweite Substrat aus Silizium oder Stahl oder Keramik besteht.

11. Funktionelle Einheit der Uhrenmikromechanik nach einem der Ansprüche 7 bis 10, **dadurch gekennzeichnet, dass** die erste und/oder die zweite Reibschicht eine Dicke von mindestens 150 nm aufweisen.

12. Funktionelle Einheit der Uhrenmikromechanik nach einem der Ansprüche 1 bis 11, **dadurch gekennzeichnet, dass** die zweite Schicht zu dem zweiten Teil (20) gehört und dass das erste Teil eine Palette (30) ist und dass das zweite Teil ein Hemmungsrad (40) ist oder umgekehrt.

13. Funktionelle Einheit der Uhrenmikromechanik nach einem der Ansprüche 1 bis 11, **dadurch gekennzeichnet, dass** die zweite Schicht zu dem zweiten Teil (20) gehört und dass das erste Teil eine Achse eines beweglichen Teils ist und dass das zweite Teil ein Lager ist oder umgekehrt.

14. Funktionelle Einheit der Uhrenmikromechanik nach einem der Ansprüche 1 bis 10, **dadurch gekennzeichnet, dass** die zweite Schicht zu dem zweiten Teil (20) gehört und dass das erste und das zweite Teil Verzahnungen von Zahnrädern sind.

15. Funktionelle Einheit der Uhrenmikromechanik nach einem der Ansprüche 1 bis 10, **dadurch gekennzeichnet, dass** die zweite Schicht zu dem ersten Teil (10) gehört und dass das erste Teil eine Federhausfeder ist, die aus einem Blatt gebildet wird, und dass eine Vorderseite des Blattes die erste Kontaktfläche bildet und dass die Rückseite des Blattes die zweite Kontaktfläche bildet.

## Claims

1. Functional micromechanical timepiece assembly (100) comprising at least one first part (10) provided with at least one first face, said at least one first face being covered with a first layer (11) defining a first contact surface (11a) intended to come into frictional contact with a second contact surface (21a) defined by a second layer (21) covering at least one second face, either of said first part (10) or of at least one second micromechanical timepiece part (20) constituting, with said first part (10), said assembly (100), the first and second layers (11, 21) each including carbon to the extent of at least 50% carbon atoms, **characterised in that** the first contact surface has a first determined crystalline plane orientation, **in that** the second contact surface has a second determined crystalline plane orientation, **in that** the first and second determined orientations are different from one another and **in that** the crystalline planes of said first layer at least at the first contact surface belong to the family of planes {111}, **in that** the direction of the crystalline planes of said first layer belonging to the family of planes {111} is tilted by an average angle of between 10° and 70°, preferably between 40° and 50°, and more preferably an average angle of 45° to the normal to said first face, **in that** the crystalline planes of said second layer at least at the second contact surface belong to the family of planes {100} and **in that** the direction of the crystalline planes of said second layer belonging to the family of planes {100} is oriented perpendicular to said second face.

2. Functional micromechanical timepiece assembly according to claim 1, **characterised in that** at least said first layer (11) has a microcrystalline structure at least at the first contact surface.

3. Functional micromechanical timepiece assembly according to claim 2, **characterised in that** said first and second layers (11, 21) each have a microcrystalline structure at least at their respective contact surface.

4. Functional micromechanical timepiece assembly according to any one of the preceding claims, **characterised in that** at least one of the first or second layers is covered at least partially by a cover layer made of another material.

5. Functional micromechanical timepiece assembly according to claim 4, **characterised in that** the cover layer is less than 100 nm thick.

6. Functional micromechanical timepiece assembly according to any one of the preceding claims, **characterised in that** said second layer belongs to said second part (20) and **in that** the first and/or second part are made of solid monocrystalline or polycrystalline diamond.

7. Functional micromechanical timepiece assembly according to any one of the preceding claims, **characterised in that** the average roughness (Rₘₛ) of one of the first or second contact surfaces is greater than 80 nm.

8. Functional micromechanical timepiece assembly according to any one of claims 1 to 7 when not dependent on claim 9, **characterised in that** said first and/or second layer defining said first contact surface and/or said second contact surface covers a first substrate in order to form said first part.

9. Functional micromechanical timepiece assembly according to any one of claims 1 to 7 when not dependent on claim 5, **characterised in that** said second layer belongs to said second part (20) and **in that** said first and/or second layer defining said first contact surface and/or said second contact surface covers a first substrate and/or a second substrate to form said first and/or said second part.

10. Functional micromechanical timepiece assembly according to claim 7 or 9, **characterised in that** the first and/or second substrate is made of silicon, steel or ceramic.

11. Functional micromechanical timepiece assembly according to one of claims 7 to 10, **characterised in that** said first and/or second friction layer has a thickness of at least 150 nm.

12. Functional micromechanical timepiece assembly according to any one of claims 1 to 11, **characterised in that** said second layer belongs to said second part (20) and **in that** the first part is a pallet stone (30) and **in that** the second part is an escape wheel (40) or vice versa.

13. Functional micromechanical timepiece assembly according to any one of claims 1 to 11, **characterised in that** said second layer belongs to said second part (20) and **in that** the first part is an arbor of a wheel set and **in that** the second part is a bearing or vice versa.

14. Functional micromechanical timepiece assembly according to any one of claims 1 to 10, **characterised in that** said second layer belongs to said second part (20) and **in that** said first and second parts are gear wheel toothings.

15. Functional micromechanical timepiece assembly according to any one of claims 1 to 10, **characterised in that** said second layer belongs to said first part (10) and **in that** the first part is a mainspring formed by a blade and **in that** a front face of said blade forms said first contact surface and **in that** the rear face of said blade forms said second contact surface.
